(19) Europäisches Patentamt

European Patent Office

Office européen des brevets

(11) **EP 1 096 261 A2**

(12) **EUROPÄISCHE PATENTANMELDUNG**

(43) Veröffentlichungstag:
02.05.2001 Patentblatt 2001/18

(51) Int. Cl.[7]: **G01R 15/14**, G01R 35/00,
G01R 19/25

(21) Anmeldenummer: 00119718.5

(22) Anmeldetag: 09.09.2000

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **30.10.1999 DE 19952529**

(71) Anmelder: **DaimlerChrysler AG**
**70567 Stuttgart (DE)**

(72) Erfinder:
• **Mäckel, Rainer, Dr.**
**53639 Königswinter (DE)**

• **Schulz, Thomas**
**72669 Unterensingen (DE)**
• **Fischer, Roland, Dr.**
**61130 Nidderau (DE)**

(74) Vertreter:
**Maute, Hans-Jürgen, Dipl.-Ing. et al**
**Daimler-Benz AG,**
**Intellectual Property Management,**
**Postfach 35 35**
**74025 Heilbronn (DE)**

(54) **Verfahren zur Strommessung an einer mehrfachen Stromverteilung**

(57) An einer mehrfachen Stromverzweigung, insbesondere an einer Batterieableitung, mit mehreren parallelen Zweigen sind an jedem Zweig Magnetfeldsensoren angebracht. Hierbei ist lediglich an einem Zweig der Stromverzweigung ein hochgenauer Master-Sensor angebracht, an den übrigen Zweigen der Stromverzweigung sind einfache unkalibrierte Sensoren angebracht. Unter Ausnutzung der Kirchhoff'schen Gesetze an Stromverzweigungen und des linearen Zusammenhangs des Sensorsignals mit der Stromstärke in den einzelnen Zweigen der Stromverzweigung werden die unkalibrierten Sensoren einfacher Bauart im eingebauten Zustand gegen den einen hochgenauen Master-Sensor kalibriert. Die Kalibrierung läßt sich beliebig oft, zu beliebigen Zeitpunkten wiederholen.

FIG.1

EP 1 096 261 A2

**Beschreibung**

Die Erfindung betrifft ein Verfahren mit den Merkmalen des unabhängigen Anspruchs.

Die Messung des Stromes über die Messung der mit dem Strom verknüpften Magnetfeldstärke ist an sich bekannt. Hierzu werden z.B. Hallsensoren oder magnetoresisitive Sensoren eingesetzt. Diese Sensoren besitzen von der Temperatur abhängige Offsets und Empfindlichkeiten. Deshalb setzt man bei handelsüblichen Hallsensoren, die als integrierte elektronische Komponenten, sog. Hall-IC's gehandelt werden, die Orthogonalumschaltung der Hallplatten ein, um die Verschiebung des Offset kompensieren zu können. Der Aufwand hierzu ist allerdings kostenintensiv. Müssen mehrere Hallsensoren verwendet werden, so addieren sich die Kosten. Insbesondere im Automobilbau, bei dem bei der Bordnetzüberwachung mehrere Sensoren eingesetzt werden müssen, ist es wünschenswert möglichst einfache Sensoren und damit kostengünstige Sensoren zu verwenden. Hallsensoren einfacher Bauart, oder magnetoresistive Sensoren einfacher Bauart, sind jedoch für hochpräzise Messungen nicht ohne weiteres geeignet. Ihre Empfindlichkeiten besitzen die übliche Exemplarstreuung und müssen erst durch einen Kalibriervorgang ermittelt werden. Diese Sensoren besitzen zudem eine erhebliche Nullpunktverschiebung (Offset), die ebenfalls bestimmt werden muß. Außerdem unterliegen die im Kraftfahrzeug eingesetzten Sensoren zahlreichen Umwelteinflüssen und insbesondere großen Temperaturschwankungen. Eine einmalige Kalibrierung der in Kraftfahrzeug-Bordnetzen eingesetzten Sensoren genügt daher in der Regel nicht.

Erfindungsgemäße Aufgabe ist es daher, ein Verfahren zur Strommessung an einer mehrfachen Stromverzweigung, insbesondere an einer Batterieableitung, mit mehreren parallelen Zweigen anzugeben, die eine hohe Genauigkeit und Auflösung aufweist und die den Einsatz von einfachen Magnetfeldsensoren ermöglicht.

Erfindungsgemäß wird diese Aufgabe gelöst durch die Merkmale des unabhängigen Anspruchs. Weitere vorteilhafte Ausführungsformen sind in den Unteransprüchen enthalten.

An einer mehrfachen Stromverzweigung, insbesondere an einer Batterieableitung, mit mehreren parallelen Zweigen sind an jedem Zweig Magnetfeldsensoren angebracht. Hierbei ist lediglich an einem Zweig der Stromverzweigung ein hochgenauer Master-Sensor angebracht, an den übrigen Zweigen der Stromverzweigung sind einfache unkalibrierte Sensoren angebracht. Unter Ausnutzung der Kirchhoff'schen Gesetze an Stromverzweigungen und des linearen Zusammenhangs des Sensorsignals mit der Stromstärke in den einzelnen Zweigen der Stromverzweigung werden die unkalibrierten Sensoren einfacher Bauart im eingebauten Zustand gegen den einen hochgenauen Master-Sensor kalibriert. Die Kalibrierung läßt sich beliebig oft, zu beliebigen Zeitpunkten wiederholen.

Mit der Erfindung werden hauptsächlich die folgenden Vorteile erzielt:

- Es können Sensoren einfacher Bauart ohne Temperaturkompensation verwendet werden.

- Eine Band-Ende-Prüfung und eine Band-Ende-Einstellung bei der Herstellung oder dem Einbau der erfindungsgemäßen Stromverzweigung muß nur mit einem Sensor vorgenommen werden, die restlichen Sensoren einfacher Bauart können nachträglich gegen den voreingestellten Master-Sensor kalibriert werden. Der Master-Sensor ist hierzu temperaturkompensiert d.h. entweder legt man die Offset-Temperaturabhängigkeit des Master-Sensors in einer Kalibrierkurve fest oder man stabilisiert die Temperatur des Master Sensors, so daß die Kalibrier-Messungen für die Sensoren einfacher Bauart stets bei gleicher Referenz-Temperatur des Master-Sensors durchgeführt werden.

- Eine genaue Stromsensorik mit Magnetfeldsensoren benötigt auch eine genaue geometrische Fixierung der Sensoren in Bezug auf die zu messenden Ströme, da die Stromstärke aus dem geometrieabhängigen Magnetfeld der Ströme bestimmt wird. Bei der erfindungsgemäßen Stromsensorik ist dies nur für den Mastersensor notwendig. Für die übrigen Sensoren einfacher Bauart werden Veränderungen der Parameter durch Änderungen der Geometrie während der Fertigung oder im Betrieb durch Wärmeausdehnung oder andere Einflüsse durch die nachträgliche und wiederholte Kalibrierung der einfachen Sensoren im eingebauten Zustand berücksichtigt.

Ein Ausführungsbeispiel der Erfindung wird im folgenden anhand von Zeichnungen dargestellt und näher erläutert. Es zeigen:

Fig.1    eine schematische Darstellung einer Stromverteilung mit mehreren parallelen Stromzweigen und an den Stromzweigen angeordneten Magnetfeldsensoren

Fig. 2    ein Ablaufdiagramm des erfindungsgemäßen Verfahrens

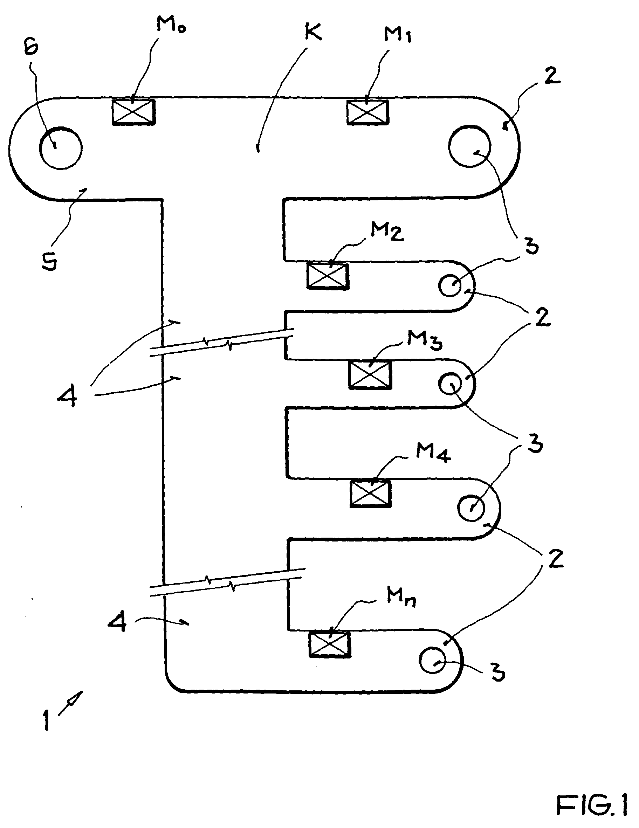

Fig.1 zeigt zur Erläuterung der Erfindung eine schematische Darstellung einer Stromverteilung 1 mit mehreren parallelen Stromzweigen 2 und an den Stromzweigen angeordneten Magnetfeldsensoren $M_0$, $M_1$, $M_2$, $M_3$,

$M_4$,..,$M_n$. Die Stromverteilung ist aus einem metallischen Leiter. Vorzugsweise wird die Stromverteilung aus einem Leiterblech ausgestanzt und ist als Stanzgitter ausgebildet. Die einzelnen parallelen Stromzweige 2 sind untereinander über eine Verteilerbrücke 4 verbunden, der senkrecht zu den Stromzweigen 2 verläuft Ebenfalls an der Verteilerbrücke 4 angebracht ist der Hauptstromzweig 5 mit dem Versorgungsanschluß 6, der im gezeigten Ausführungsbeispiel als Anschlussöse ausgebildet ist. Die einzelnen Stromzweige 2 verfügen jeweils über einen Verbraucheranschluß 3, der ebenfalls als Anschlussöse ausgebildet ist. Über den Versorgungsanschluß 6 wird der gesamte Strom in den Hauptstromzweig 5 eingespeist und über die Verteilerbrücke 4 auf die einzelnen parallelen Stromzweige 2 zu den Verbraucheranschlüssen 3 verteilt. Am Hauptstromzweig ist der Magnetfeldsensor $M_0$ angebracht, der den am Versorgungsanschluß einzuspeisenden Gesamtstrom erfaßt. Weiterhin ist an jedem einzelnen parallelen Stromzweig 2 jeweils ein Magnetfeldsensor $M_1$, $M_2$, $M_3$, $M_4$, ...,$M_n$ angeordnet, der jeweils den in dem einzelnen parallelen Stromzweig fließenden Verbraucherstrom erfaßt. Die Magnetfeldsensoren sind in einer bevorzugten Ausführungsform der Erfindung als Hallsensoren ausgebildet. In einer weniger bevorzugten Ausführungsform der Erfindung sind die Magnetfeldsensoren als magnetoresistive Sensoren ausgebildet.

In einer besonders bevorzugten Ausführungsform der Erfindung ist die Stromverteilung 1 als Batterieableitung in einem Kraftfahrzeug ausgebildet.

Die Anzahl der parallelen Stromzweige 2 kann nahezu beliebig gewählt werden und richtet sich nach der Anzahl der vorgesehenen Verbraucher, die an die Stromverteilung angeschlossen werden sollen. Im gezeigten Ausführungsbeispiel ist deshalb der Stromzweig mit dem Magnetfeldsensor $M_n$ andeutungsweise mit einer unterbrochenen Linie an die Verteilerbrücke 4 angeschlossen.

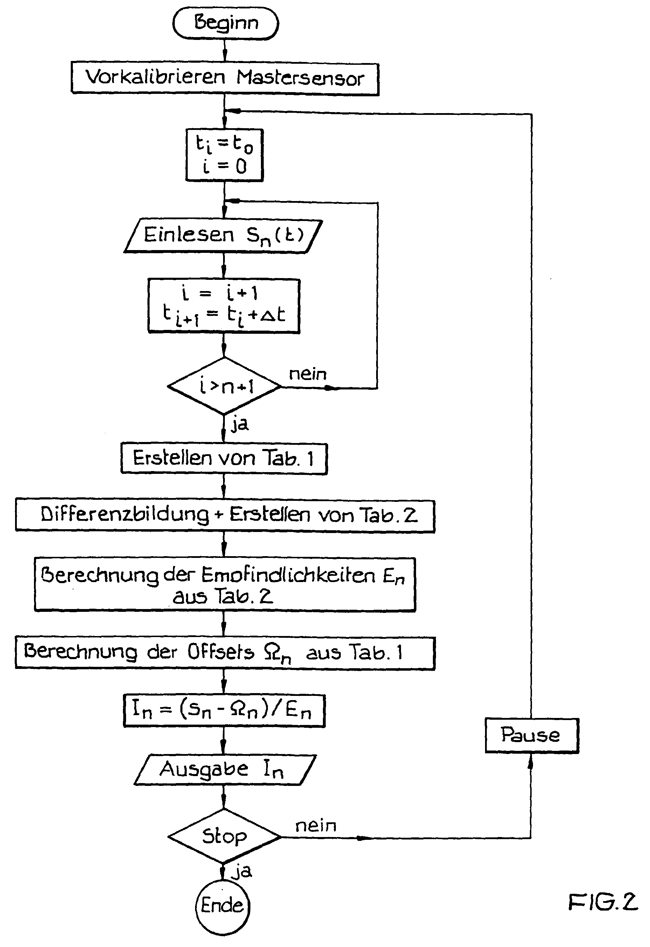

Fig. 2 zeigt ein Ablaufdiagramm des erfindungsgemäßen Verfahrens. Die Kalibrierung der Sensoren $M_0$, $M_1$, $M_2$, $M_3$, $M_4$,..,$M_n$ gelingt unter Ausnutzung der Kirchhoff'schen Gesetze an Stromverzweigungen und der Annahme eines linearen Zusammenhangs des Sensorsignals $S_n$ mit der Stromstärke In. In dem Ausführungsbeispile nach Fig. 1 gilt am Knoten K zur Zeit t:

$$I_0(t) = I_1(t) + I_2(t) + I_3(t) + I_4(t) + ...+ I_n(t) \qquad 1)$$

wobei die Indices die Nummern der Sensoren $M_n$ angeben.

Für die Signalwerte Sn der Sensoren $M_n$ in Abhängigkeit von den Stromwerten $I_n$ und den Offsets $\Omega_n$ zum Zeitpunkt t gilt der lineare Zusammenhang

$$S_n(t) = E_n * I_n(t) + \Omega_n \qquad 2)$$

Gleichung 2) in Gleichung eingesetzt ergibt also:

$$(S_0(t) - \Omega_0)/E_0 = (S_1(t) - \Omega_1)/E_1 + (S_2(t) - \Omega_2)/E_2 + (S_3(t) - \Omega_3)/E_3 + (S_4(t) - \Omega_4)/E_4 + ..+(S_n(t) - \Omega_n)/E_n \qquad 3)$$

In Gleichung 3) sind die Sensorsignale jeweils bekannt, da sie gemessen werden. Ebenfalls bekannt sind die Empfindlichkeit und der Offset des vorkalibrierten Master-Sensor Welcher Sensor als Master-Sensor vorkalibriert wird, kann frei gewählt werden. In dem hier beschriebenen Ausführungsbeispiel sei beispielhaft der Sensor $S_0$ der vorkalibrierte Master-Sensor. Unbekannte Größen sind die Empfindlichkeiten $E_1$, $E_2$,..$E_n$ und die Offsets $\Omega_1$, $\Omega_2$,..,$\Omega_n$. Die Gleichung enthält also eine Anzahl von 2n zunächst unbekannten Größen. Durch Messung der Sensorsignale zu verschiedenen Zeiten $t_0$, $t_1$, $t_2$, $t_3$, $t_4$,..,$t_n$ mit verschiedenen Sensorsignalen kann ein lineares Gleichungssystem für Gleichung 2) gewonnen werden, das im folgenden als Matrix in Tabelle 1 dargestellt wird.

| | M0 | M1 | ... | Mn |
|---|---|---|---|---|
| $t_0$ | $S_0(t_0)$ | $S_1(t_0)$ | ... | $S_n(t_0)$ |
| $t_1$ | $S_0(t_1)$ | $S_1(t_1)$ | ... | $S_n(t_1)$ |
| ... | ... | ... | ... | ... |
| $t_n$ | $S_0(t_n)$ | $S_1(t_n)$ | ... | $S_n(t_n)$ |
| $t_{n+1}$ | $S_0(t_{n+1})$ | $S_1(t_{n+1})$ | ... | $S_n(t_{n+1})$ |

wobei die Matrixelemente Sn(tn) die Signalwerte der Sensoren Mn zum Zeitpunkt $t_n$ entsprechend der Gleichung 2) sind. Die Matrixelemente enthalten also noch die unbekannten Offsets $\Omega_0$, $\Omega_1$,...$\Omega_n$. Diese Offsets sind jedoch nicht zeitabhängig und lassen sich deshalb durch Differenzenbildung der Sensorsignale zu jeweils zwei verschiedenen Zeitpunkten t, t' aus Gleichung 2) bzw. aus Gleichung 3) eliminieren gemäß

$$(S_0(t') - S_0(t))/E_0 = (S_1(t') - S_1(t))/E_1 + (S_2(t') - S_2(t))/E_2 + (S_3(t') - S_3(t))/E_3$$
$$+ (S_4(t') - S_4(t))/E_4 + \ldots + (S_n(t') - S_n(t))/E_n$$

$$4)$$

Hierdurch erhält man ein Gleichungssystem bei dem die Offsets der Magnetfeldsensoren wegfallen und nur noch die Empfindlichkeiten der Sensoren als Unbekannte enthalten sind.

Man muß also nicht ein Gleichungssystem mit 2n Unbekannten lösen, sondern zwei Gleichungssysteme mit jeweils n Unbekannten. Aus der Matrix entsprechend Tabelle 1 läßt sich deshalb mit Vorteil durch Differenzenbildung entsprechend der Gleichung 4) eine Untermatrix bilden, deren Matrixelemente die Differenz jeweils zweier Sensorsignale eines Sensors zu zwei verschiedenen Zeitpunkten enthalten. Es ergibt sich die Matrix nach der folgenden Tabelle 2

|  | $\Delta S_0$ | $\Delta S_1$ | $\Delta S..$ | $\Delta S_n$ |
|---|---|---|---|---|
| $t_1, t_0$ | $S_0(t_1) - S_0(t_o)$ | $S_1(t_1) - S_1(t_0)$ | ... | $S_n(t_1) - Sn(t_0)$ |
| $t_2, t_0$ | $S_0(t_2) - S_0(t_o)$ | $S_1(t_2) - S_1(t_0)$ | ... | $S_n(t_2) - S_n(t_0)$ |
| ... | ... | ... | ... | ... |
| $t_{n+1}, t_0$ | $S_0(t_{n+1}) - S_0(t_0)$ | $S_0(t_{n+1}) - S_0(t_0)$ | ... | $S_n(t_{n+1}) - S_n(t_0)$ |

Das Gleichungssystem entsprechend der Matrix aus Tabelle 2 enthält somit n-Gleichungen (n Zeilen) für die n-Unbekannten Empfindlichkeiten $E_n$. Ein derartiges Gleichungssystem läßt sich durch z.B. einen Mikroprozessor auswerten und lösen. Aus der Theorie zur Lösung linearer Gleichungssysteme ergeben sich zwei Randbedingungen für das Vorhandensein einer nichtrivialen und eindeutigen Lösung für die unbekannten Empfindlichkeiten. Zum einen müssen die Gleichungen des Gleichungssystems linear unabhängig sein. Diese Randbedingungen kann in einem Bordnetz eines Kraftfahrzeuges dadurch erfüllt werden, indem zu den verschiedenen Zeitpunkten an denen die Meßsignale aufgenommen werden in den einzelnen Zweigen der Stromverteilung jeweils unterschiedliche elektrische Verbraucher zugeschaltet werden. Damit das Gleichungssystem aus Tabelle 2 eine nichttriviale Lösung für die Empfindlichkeiten aufweist, muß genau eine Spalte vorbekannt sein, da ansonsten das Gleichungssystem ein homogenes Gleichungssystem darstellt, das bekanntlich nur die triviale Lösung hat. Dies wird in der erfindungsgemäßen Stromverzweigung dadurch sichergestellt, daß ein Sensor vorkalibriert wird. Es ist unerheblich welcher Sensor vorkalibriert wird. Wird beispielhaft der Sensor $M_0$ vorkalibriert eingebaut, so sind für diesen Sensor die Empfindlichkeit $E_0$ und der Offset $\Omega_0$ bekannt, d.h. in der Spalte $\Delta S_0$ sind keine Unbekannten mehr enthalten und das Gleichungssystem für die restlichen Unbekannten $E_1, E_2, \ldots E_n$ ist ein inhomogenes Gleichungssystem, daß eine eindeutige von Null verschiedene Lösung für die Empfindlichkeiten $E_1, E_2, \ldots, E_n$ hat. Technisch bedeutet dies, daß die Empfindlichkeiten der Sensoren $M_1$, $M_2, \ldots, M_n$ durch Lösung des Gleichungsystems entsprechend Tabelle 2 gegen den beispielhaft gewählten Mastersensor $M_0$ gegenkalibriert werden.

Aufbauend auf diesen Überlegungen läßt sich das in Fig. 2 gezeigte erfindungsgemäße Kalibrierungsverfahren für die Sensoren der erfindungsgemäßen Stromverteilung wie sie beispielhaft in Fig. 1 gezeigt ist angeben. Hierbei wird zunächst in einem ersten Verfahrensschritt ein Master-Sensor, z.B. der Sensor $M_0$ vorkalibriert. In einem weiteren Verfahrensschritt wird zu einem beliebigen aber festen Zeitpunkt $t_0$ ein erster ( i=1) Satz von Meßsignalen $S_n(t)$ in einem Speicher eines Mikroprozessors eingelesen. Zu verschiedenen späteren Zeitpunkten $t_{i+1}$ wird jeweils ein weiterer Satz von Meßsignalen $S_n(t)$ in einen Speicher eines Mikroprozessors eingelesen. Die Anzahl der Meßwertsätze die eingelesen werden, richtet sich nach der Anzahl der Sensoren, die sich in der Stromverzweigung befinden. Die Anzahl der Meßwertsätze, die zur Kalibrierung der Sensoren nach dem erfindungsgemäßen Verfahren notwendig ist, übersteigt die Anzahl der Sensoren in der Stromverzweigung um eins.

Wenn alle notwendigen Meßwerte eingelesen sind, wird im Mikroprozessor zunächst die vorbeschriebene Tabelle 1 erzeugt. Es ist auch möglich die Meßwertsätze direkt in die vorbeschriebene Tabelle 1 einzulesen. In einem weiteren Schritt wird aus der Tabelle 1 durch Differenzbildung wie vorbeschrieben die Tabelle 2 erzeugt. In einem weiteren Schritt werden - aus der Tabelle 2 in Zusammenhang mit Gleichung 4) mit an sich bekannten mathematischen Algorithmen zur Lösung linearer Gleichungssysteme in vorbeschriebener Weise die Empfindlichkeiten $E_n$ der Sensoren einfacher Bauart aus den Meßsignalen des vorkalibrierten Master-Sensor bestimmt. Im vorbeschriebenen Beispiel ist der Master-Sensor der Sensor $M_0$.

Sind die einzelnen Empfindlichkeiten $E_n$ der Sensoren $M_n$ ermittelt können aus der Tabelle 1 in Zusammenhang mit Gleichung 3) die Offsets $\Omega_n$ der Sensoren ermittelt werden. Die Tabelle 1 stellt nun, da die Empfindlichkeiten ermittelt wurden, im Zusammenhang mit der Gleichung 3) ebenfalls ein lineares Gleichungsystem dar mit den Unbekannten $\Omega_0$, $\Omega_1$, $\Omega_2$, ..$\Omega_n$. Da für die Differenzbildung entsprechend Gleichung 4) zur Erstellung der Tabelle 2 ein Meßwertsatz mehr eingelesen werden mußte als Sensoren vorhanden sind, ist das aus der Tabelle 1 in Verbindung mit der Gleichung 3 resultierende Gleichungsystem überbestimmt. Um Schwierigkeiten bei der Auswertung des linearen Gleichungssystems mit dem Mikroprozessor zu vermeiden, ist es deshalb zweckmäßig sich bei der Berechnung der Offsets $\Omega_n$ auf eine Untermenge der durch Tabelle 1 gegebenen Gleichungen zu beschränken. Berücksichtigt man ferner, daß der Master-Sensor $M_0$ bereits vorkalibriert ist, genügt es, sich für die Berechnung der noch unbekannten Offsets der Sensoren einfacher Bauart auf n Gleichungen zu beschränken. Es sei hier nochmals bemerkt, daß die Gleichungen entsprechend der Randbedingungen zur Kalibrierung der Empfindlichkeiten linear unabhängig sind, so daß mit den bereits vorbeschriebenen Methoden zur Lösung linearer Gleichungsysteme eine eindeutige Lösung zur Berechnung der Offsets $\Omega_1$, $\Omega_2$,..$\Omega_n$ existiert.

Damit sind nun sämtliche Sensoren der erfindungsgemäßen Stromverteilung ein erstes mal kalibriert. Deshalb können nun in einem weiteren Schritt entsprechend der folgenden Gleichung

$$I_n = (S_n - \Omega_n)/E_n \qquad\qquad 5)$$

die zu den Sensorsignalen zugehörigen Ströme berechnet werden und ausgegeben werden. Die Ausgabe der Stromwerte erfolgt hierbei z.B. in einen Meßwertspeicher.

Nach einer vorbestimmbaren Pause kann der Kalibriervorgang für die unkalibrierten Sensoren einfacher Bauart falls erforderlich wiederholt werden. Der Kalibriervorgang für die unkalibrierten Sensoren einfacher Bauart ist rekursiv. Eine Wiederholung des Kalibriervorgangs ist insbesondere dann erforderlich, falls durch z.B. Temperaturänderungen ein Driften der Sensoren zu erwarten ist. Die Dauer der Pause ist hierbei frei wählbar.

**Patentansprüche**

**1.** Verfahren zur Strommessung an einer mehrfachen Stromverzweigung mit Stromsensoren ($M_0$,$M_1$,$M_2$,..$M_n$) mit linearem Signal-Strom Zusammenhang, wobei sich die Stromsensoren jeweils in verschiedenen, getrennten Strompfaden ( 2,5) befinden, die sich alle in einem gemeinsamen Knoten (K) treffen, und ein Stromsensor ein Master-Sensor ($M_0$) ist und die übrigen Sensoren unkalibrierte Sensoren einfacher Bauart sind, umfassend,

einen ersten Verfahrensschritt, in dem der Master-Sensor ($M_0$) vorkalibriert wird,
einen weiteren Verfahrensschritt zu einem Zeitpunkt ($t_0$), in dem ein erster Meßwertsatz ($S_0(t_0)$, $S_1(t_0)$,$S_2(t_0)$,...,$S_n(t_0)$) von Meßwerten aus allen Stromsensoren ($M_0$, $M_1$, $M_2$,...,$M_n$) in einen Mikroprozessor eingelesen wird,
weitere Verfahrensschritte zu nachfolgenden Zeitpunkten ($t_i$), in denen weitere Meßwertsätze ($S_0(t_i)$, $S_1(t_i)$,$S_2(t_i)$,..,$S_n(t_i)$) von Meßwerten aller Stromsensoren ($M_0$,$M_1$,$M_2$,..,$M_n$) in einen Mikroprozessor eingelesen werden, solange bis die Anzahl der eingelesenen Meßwertsätze die Anzahl der Sensoren um eins übersteigt,
einen weiteren Verfahrensschritt in dem die eingelesenen Meßwertsätze in einer ersten Matrix (Tabelle 1) zur Lösung von linearen Gleichungssystemen abgespeichert werden,
einen weiteren Verfahrensschritt in dem aus der ersten Matrix durch Differenzbildung der Meßwerte aus zwei verschiedenen Zeitpunkten t, t' nach der Gleichung

$$(S_0(t') - S_0(t))/E_0 = (S_1(t')-S_1(t))/E_1 + (S_2(t') - S_2(t))/E_2 + (S_3(t') - S_3(t))/E_3$$
$$+ (S_4(t') - S_4(t))/E_4 +....+ (S_n(t') - S_n(t))/E_n$$

eine zweite Matrix (Tabelle 2) zur Lösung von linearen Gleichungssystemen gewonnen wird, bei der die Offsets ($\Omega_0$,$\Omega_1$,$\Omega_2$,..,$\Omega_n$) der Stromsensoren rechnerisch eliminiert sind,
einen weiteren Verfahrensschritt, in dem aus dem linearen Gleichungssystem, das der zweiten Matrix (Tabelle 2) zugrunde liegt, die Empfindlichkeiten ($E_1$,$E_2$,$E_3$,..,$E_n$) der Sensoren einfacher Bauart aus den Meßwertsignalen ($S_0(t_i)$) des Master-Sensor ($M_0$) berechnet werden,
einen weiteren Verfahrenschritt, in dem die berechneten Empfindlichkeiten ($E_1$,$E_2$,$E_3$,..,$E_n$) in die Gleichung

$$(S_0(t) - \Omega_0)/E_0 = (S_1(t) - \Omega_1)/E_1 + (S_2(t) - \Omega_2)/E_2 + (S_3(t) - \Omega_3)/E_3$$
$$+ (S_4(t) - \Omega_4)/E_4 + .. + (S_n(t) - \Omega_n)/E_n$$

eingesetzt werden und in dem die Offsets $(\Omega_1, \Omega_2, ..., \Omega_n)$ der Sensoren einfacher Bauart aus dem linearen Gleichungssystem, das der ersten Matrix (Tabelle 1) zugrunde liegt, berechnet werden,
einen weiteren Verfahrensschritt, in dem aus den abgespeicherten Meßwertsätzen und den bestimmten Empfindlichkeiten und den bestimmten Offsets die Ströme $(I_n)$ in den Strompfaden (2,5) berechnet und ausgegeben werden.

2. Verfahren nach Anspruch 1, dadurch gekennzeichnet, daß der Master-Sensor $(M_0)$ temperaturkompensiert ist.

3. Verfahren nach Anspruch 1 oder 2, dadurch gekennzeichnet, daß die Berechnung der Empfindlichkeiten $(E_1, E_2, E_3, .., E_n)$ und der Offsets $(\Omega_1, \Omega_2, ..., \Omega_n)$ der Sensoren einfacher Bauart nach einer Pause wiederholt werden kann.

4. Verfahren nach einem der Ansprüche 1 bis 3 , dadurch gekennzeichnet, daß die Kalibrierung der Stromsensoren $(M_0, M_1, M_2, ...M_n)$ jeweils bei der gleichen Referenztemperatur des Master-Sensors $(M_0)$ durchgeführt wird.

5. Verfahren nach einem der Ansprüche 1 bis 4, dadurch gekennzeichnet, daß die OffsetTemperaturabhängigkeit des Master-Sensors $(M_0)$ in einer Kalibrierkurve abgelegt ist.

6. Verfahren nach einem der Ansprüche 1 bis 5 zur Strommessung an einer Batterieableitung.

FIG.1

Beginn

Vorkalibrieren Mastersensor

$t_i = t_o$
$i = 0$

Einlesen $S_n(t)$

$i = i+1$
$t_{i+1} = t_i + \Delta t$

$i > n+1$ — nein

ja

Erstellen von Tab. 1

Differenzbildung + Erstellen von Tab. 2

Berechnung der Empfindlichkeiten $E_n$ aus Tab. 2

Berechnung der Offsets $\Omega_n$ aus Tab. 1

$I_n = (s_n - \Omega_n)/E_n$

Ausgabe $I_n$

Stop — nein

ja

Ende

Pause

FIG. 2